# EUROPEAN PATENT APPLICATION

(11) **EP 0 580 920 A1**
(43) Date of publication of application: **02.02.1994**
(21) Application number: 92830419.5
(22) Date of filing: 28.07.1992
(51) Int. Cl.: G06G 7/62, G11C 27/02

(54) **Integrated capacitance multiplier and RC circuit**

(71) Applicant: SGS-THOMSON MICROELECTRONICS S.r.l., I-20041 Agrate Brianza (Milano) (IT)
(72) Inventor: Ferrario, Bruno, I-22073 Fino Mornasco (IT)
(74) Representative: Pellegri, Alberto

(57) **Abstract**

An integrated capacitance multiplier circuit utilizes a pair of field effect transistors, biased in a conducting state, as virtual resistances of a classic operational amplifier network for implementing a capacitance multiplier function. The two field effect transistors have different sizes from each other for attaining a given ON-resistance ratio. A biasing circuit provides independently adjustable biasing voltages for the two field effect transistors. At least one of the two biasing voltages produced by the biasing circuit can be made dependent on temperature according to a certain dependency law in order to exploit the capacitance multiplier circuit for temperature compensating an integrated RC circuit employing the virtual capacitance provided by the multiplier circuit.

## Description

In an integrated circuit it is hardly possible to realise large capacitances. In fact, capacitance is directly proportional to the area of semiconducting substrate which may be used for integrating a capacitor. On the other hand, several functional circuits require the use of relatively high capacitances. For example, a low-pass RC filter for frequencies in the order of 10 Hz requires high resistance (R) and capacitance (C) values and, in particular, a capacitance value which is physically hardly implementable in an integrated circuit. The problem may be resolved by the use of a so-called capacitance multiplier circuit. Several circuits which implement the function of a multiplier of the capacitance of a real (physical) capacitor (having an easily integratable size) and which are commonly based on an operational amplifier network are described in literature.

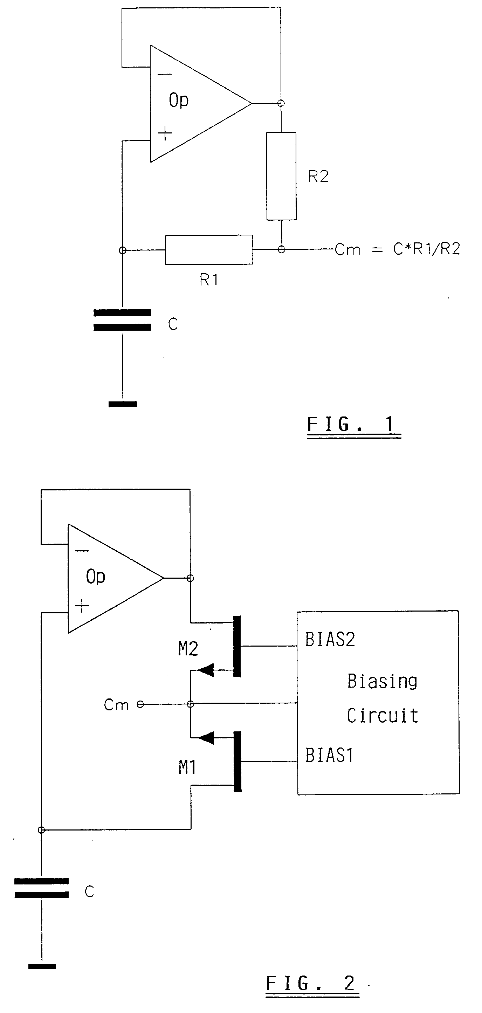

A typical capacitance multiplier circuit which may be easily integrated is shown in **Fig. 1**. The intermediate node between the two resistances R1 and R2 constitutes the terminal of a "virtual" capacitor having a capacitance given by:

$\text{Cm = R1/R2 C}$

where C is the capacitance of a physically integrated capacitor).

In order to obtain a virtual capacitance of about 10nF from a physical capacitance of about 100pF, it is necessary to use two well matched integrated resitances having a resistance ratio equal to about 100. Moreover, the smaller resistance (R2) should advantageously have a relatively small value because it determines the series resistance of the virtual capacitance which is obtained.

The realization of a pair of well matched integrated resistances having a relatively large resistance ratio which should remain practically constant throughout a certain temperature range, is not a technically insoluble problem but the solution of which requires a rather large area of the semiconducting substrate of the integrated circuit.

An alternative and more advantageous solution is provided by the present invention whose object is an improved capacitance multiplier circuit which utilizes two field effect transistors in place of the two resistances connected in series which are normally used in a capacitance multiplier circuit of the prior art. In the circuit of the invention, a given resistance ratio is functionally implemented by the ratio between the ON-resistances (channel resistances) of the two field effect transistors, which have dimensions, commonly indicated in terms of channel width (w) and channel length (1) designed so as to obtain the desired ratio between the respective ON-resistances. Of course, the two field effect transistors are essentially used in a state of conduction, by suitably biasing a control gate of latch transistor.

The advantages of the capacitance multiplier circuit of the invention are remarkable, especially in terms of a greater versatility of the circuit as compared with known circuits using two integrated resistances. In many cases, the circuit of the invention permits also a saving of semiconductor area.

According to a particularly preferred embodiment of the invention, the use of two field effect transistors, each having a source region and a drain region separated by a channel region topped by a control gate structure to which a controlled biasing voltage may be applied, permits to implement an RC circuit utilizing an integrated resistance (R) and as capacitance (C)the virtual capacitance produced by means of the multiplier circuit of the invention, which is intrinsically temperature-compensated. This is possible because the biasing voltage which is applied to the control gate of any one of the two transistors may be varied independently from the biasing voltage which is applied to the another transistor.

According to such a preferred embodiment, the capacitance multiplier circuit of the invention is provided with a biasing circuit having at least two output nodes which are connected to the control gate of the two field effect transistors, respectively, of the functional multiplier circuit. Each of the voltages which are produced on said output nodes of the biasing circuit, or only one of them, may be generated according to a certain temperature-dependency law, for varying the ratio between the channel resistances of the two field effect transistors in function of the temperature, in order to compensatate the variation with temperature of the value of the integrated resistance which forms the functional RC circuit.

In this way, an integrated RC circuit may be implemented by using a capacitance having a multiplied virtual value as referred to the value of a physically integrated capacitance and which moreover is perfectly temperature compensated.

Of course, for applications where such a temperature compensation is not necessary or required, the two field effect transistors may be biased with substantially fixed voltages.

**Fig. 1** is a functional diagram of a capacitance multiplier circuit in accordance with the prior art, as described above.

**Fig. 2** is a functional diagram of a capacitance multiplier circuit according to a preferred embodiment of the invention.

With reference to **Fig. 2**, a capacitance multiplier circuit of the invention essentially comprises an operational amplifier Op, configured as a buffer, i.e. as a non-inverting, unit gain, voltage follower circuit, having an output node which is directly connected to an inverting input thereof. A physical capacitance C of a value which may be integrated, is connected between a common potential node of the circuit (e.g. ground) and a non-inverting input of the operational amplifier. The multiplying network is functionally composed of two field effect transistors, M1 and M2, respectively, functionally connected in opposition among each other between the output node of the amplifier and said non-inverting input (to which the physical capacitor C is connected).

In the example shown in **Fig. 2**, the two field effect transistors are n-channel transistors, having their respective source regions connected in common. The M2 transistor has a drain connected to the output node of the amplifier and the M1 transistor has a drain connected to the non-inverting input of the amplifier. The respective sizes of the two transistors, M1 and M2, are such as to determine a certain desired ratio between the respective channel resistances of the transistors when they are in a conduction state, as determined by the biasing conditions established through the respective control gates.

The operation of the multiplier circuit is similar to that of the known circuit of **Fig. 1** and the connection node Cm between the two field effect transistors M2 and M1 constitutes the terminal of a virtual capacitance given by: ${\text{Cm = R}}_{\text{M1}} {\text{/R}}_{\text{M2}} \text{C}$ , wherein R_{M1} is the actual channel resistance of transistor M1 and R_{M2} is the channel actual resistance of the M2 transistor, at the respective biasing conditions.

A biasing circuit produces on two output nodes (BIAS 1 and BIAS 2), biasing voltages for the transistors M1 and M2, respectively. The value of the voltages produced by the biasing circuit may be substantially constant, or the value of one and/or of the other or also of only one of the two voltages may be made dependent on temperature in accordance with a certain law of dependency. The biasing voltages: BIAS1 and BIAS2, are fed to the gate terminal of the field effect transistors M1 and M2, respectively. As already said above, this permits to obtain, whenever of utility, a certain dependence of the value of the ratio between the respective channel resistances of the two transistors, in function of the temperature variation. When implementing an integrated RC filter circuit, such a possibility of variation of the resistive ratio between the two channel resistances of the transistors M1 and M2, respectively, may be exploited for compensating a corresponding variation of the value of an integrated resistance (R) of the RC circuit with a temperature variation. In other words, the capacitance multiplier circuit according to this preferred embodiment may be exploited for implementing temperature compensated integrated RC circuits.

As will be evident to a skilled technician, the two field effect transistors M1 and M2 of the circuit of the invention may also be p-channel transistors. Also in this case, the two transistors will have their source connected in common to the node Cm and would have their respective drains connected to a terminal of a physical capacitor C and to the output node of the buffer Op, respectively. Of course, in this case the biasing voltages for the two transistors (BIAS 1 and BIAS 2), may be negative as referred to the ground potential.

## Claims

1. A capacitance multiplier circuit comprising a non-inverting operational amplifier configured as a voltage follower, a physically integrated capacitor of a certain capacitance having a terminal connected to a non-inverting input of the amplifier, a network comprising two resistances having a certain resistance ratio between each other, functionally connected in series between an output node of the amplifier and said non-inverting input, the connection node between said series connected resistances constituting a terminal of a virtual capacitance equal to the product of the capacitance of said physical capacitor by said ratio,
characterized by comprising
two field effect transistors, each having a control gate, a source region and a drain region separated by a channel region of dimensions suitable to produce a certain ratio between respective channel resistances of said two transistors under conducting conditions, said transistors being functionally connected in opposition to each other between said output node and said non-inverting input of the operational amplifier and biased in a state of conduction.

2. A capacitance multiplier circuit as defined in Claim 1, further comprising
a biasing circuit having at least two output nodes on which a biasing voltage is produced by the circuit and which are connected to the control gate of said two transistors, respectively; the circuit being capable of generating on at least one of said output nodes a biasing voltage that is a function of temperature for varying the ratio between the channel resistances of said two transistors in function of temperature.

3. A capacitance mulitplier circuit as defined in Claim 2, characterized by being an integrated circuit.

4. A temperature compensated integrated RC circuit comprising a capacitance multiplier circuit as defined in Claim 3, and wherein a variation with temperature of the resistance value of the RC circuit is compensated by a variation of the value of the virtual capacitance of the RC circuit as produced by said capacitance multiplier circuit.

5. A method for temperature compensating an integrated RC circuit which comprises an integrated resistor, an integrated capacitor and an integrated capacitance multiplier circuit capable of virtually multiplying the capacitance of said integrated capacitor by a term given by the ratio between two resistances, characterized by comprising:
a) utilizing as said two resistances the ON resistances of two field effect transistors of different size;
b) biasing at least one of said transistors with a temperature dependent voltage for modifying the relative ON-resistance of the transistor and said ratio between ON resistances in function of temperature thus varying the virtual capacitance value of the RC circuit in function of temperature to compensate a variation of the value of the integrated resistor of the RC circuit.
